(19) Europäisches Patentamt
European Patent Office
Office européen des brevets

(11) Publication number: **0 464 371 A1**

# (12) EUROPEAN PATENT APPLICATION

(21) Application number: **91108775.7**

(22) Date of filing: **29.05.91**

(51) Int. Cl.$^5$: **C08J 5/18**, B32B 15/08, B32B 27/34, //(C08J5/18, C08L79:08)

(30) Priority: **06.07.90 US 549334**

(43) Date of publication of application: **08.01.92 Bulletin 92/02**

(84) Designated Contracting States: **DE FR GB IT**

(71) Applicant: **International Business Machines Corporation**
**Old Orchard Road**
**Armonk, N.Y. 10504(US)**

(72) Inventor: **Davis, Charles R.**
**940 Hill Avenue**
**Endicott, N.Y. 13760(US)**
Inventor: **Goldblatt, Ronald D.**
**242 South Ridge Street**
**Rye Brook, N.Y. 10573(US)**
Inventor: **Park, Jae M.**
**Bonny Drive**
**Somers, N.Y. 10589(US)**

(74) Representative: **Mönig, Anton, Dipl.-Ing. et al**
**IBM Deutschland GmbH Patentwesen und Urheberrecht Schönaicher Strasse 220**
**W-7030 Böblingen(DE)**

## (54) Polyamic acid structures, and methods of fabrication thereof.

(57) A structure comprising a free-standing polyamic acid film substantially free of phthalic acids. A method of fabricating such a structure which comprises applying a polyamic acid solution to a substrate, partially or substantially completely removing the solvent from the polyamic acid solution by heating the same, removing the free-standing polyamic acid film which is free from phthalic acids, laminating the film to a substrate at elevated temperature and pressure and thermally curing the laminated, free-standing polyamic acid film to the corresponding polyimide. A structure comprising one or a plurality of such free-standing polyamic acid films with electrically conducting layers therebetween is also disclosed as is a method of fabricating such a structure. Further disclosed is the use of a thermoplastic polyimide adhesive precursor which permits 2nd level multilayer packaging applications and a method for forming such packaging.

EP 0 464 371 A1

The present invention relates to polyamic acid structures and methods for fabricating the same.

Commercially available polyamic acids, the precursor to polyimides, have many outstanding characteristics which make them very attractive for application as dielectrics in electronic packaging. For example, in the polyamic acid state, the material is processable and can be applied to substrates of interest via conventional techniques, e.g., spin coating, and, once fully cured to the polyimide state, one obtains a material that offers a low dielectric constant, good chemical resistance, excellent thermal stability and, in the instance of a polyimide having a rigid rod chemical structure, e.g., BPDA-PPD, a low coefficient of thermal expansion.

Polyamic acids, as received from vendors, are in solution with high boiling point solvents and presently have limited process applications in the industry. For example, in addition to spin coating, the other commonly utilized methods are spray and dip coating. Following the polyamic acid deposition, the coating typically undergoes solvent drying and thermal curing to the objective polyimide.

These conventional deposition methods have several inherent limitations which have resulted in restricting the use of polyamic acids. For example, although thin films are easily obtained, in order to obtain uniform thick films, e.g., on the order of 0.025 mm (1 mil), difficulties are encountered in a single process step. A commonly used method by those skilled in the art is a multiple coating process. An example illustrating when thicker dielectric spacings are necessary is when low resistance lossless circuit lines are required for high power devices such as emitter coupled logic (ECL) devices.

As one skilled in the art will appreciate, multiple coating procedures are rather complicated and time consuming. Additionally, the use of a multiple coating process increases the risk of defect introduction. For example, multiple coating applications offer the potential to impede uniform layer imidization, for example, each coating applied via the multiple coating process has a different thermal history. There is also the concern of material uniformity in thickness from point to point across the coated layers presented with several of the commonly used methods.

U.S. Patent 3,428,602 to Haller discloses polyimide articles with relatively thick cross sections which are prepared by subjecting a dilute solution of a polyamide acid precursor to a shearing action at elevated temperature but below the heat curing temperature to remove most of the solvent and then increasing the temperature to drive off the remaining solvent and convert the polyamide acid into the polyimide.

U.S. Patent 4,522,880 Klostermeier et al discloses a flexible laminate consisting of a no longer moldable layer of a fully aromatic polyimide and a substrate and a method for forming a polyimide layer directly on a substrate to form a laminate in which the layers are tightly adhered without an adhesive layer intermediate the polyimide layer and the supporting substrate layer. The polyimides are obtained from polyamic acids by an extrusion and curing process where a polyamic acid film is extruded onto the substrate and then the extruded film is cured with a thermal treatment in at least two stages.

U.S. Patent 4,687,611 Sroog discloses a polyimide film prepared from a precursor solution of polyamic acid in a solvent. A small amount of an alkyl ester of phthalic, terephthalic or isophthalic acid is added to the precursor solution as a mandatory component. The solution is cast onto a flat surface and heated thereon at about 100 - 200 °C. The resulting partially converted film is removed from the flat surface and heated under restraint to about 200 - 375 °C to bring about complete conversion and remove virtually all of the solvent. The product polyimide films are stated to show high temperature resistance and to be useful in circuit boards for electronic equipment.

U.S. Patent 4,709,468 Wilson discloses forming a multilayer polyimide and conductor film by a casting process on, for example, a polished, oxidized silicon or quartz substrate. In one embodiment alternate layers of polyamic acid resin and conductor are sequentially formed on the substrate, the conductor layers, for example, being formed by sputtering and patterning by conventional photolithographic techniques and the polyamic acid resin layers being constructed by a wafer cast method. As the multilayer film is being fabricated the successive layers of polyamic acid resin are partially cured to resist photolithographic processing chemicals which are still capable of adhering to subsequently formed polyamic resin layers. After the formation of the film has been completed, it is cured in a final cure process at 450 °C in an inert atmosphere to completely convert the polyamic acid resin to a polyimide film and to anneal the micropolymer structure.

A publication which provides an interesting discussion of polymer interlayer dielectrics in semiconductor technology, including polyimide precursors, is The Evolution of Packaging Dielectrics, Craig C. Shuckert, G.B. Fox, B.T. Merriman, E.I. duPont de Nemours & Co., Inc.; Semiconductor Materials, Electronics Department, Wilmington, DE 19898.

It is the object of the invention to provide a method of producing thick polyamic acid films which does not require repeated solvent removal and which permits much more rapid second level packaging (SLP) than prior art techniques.

In accordance with the present invention a structure comprising free-standing polyamic acid films which are free of phtalic acids is formed. The polyamic acid films are self-adhering to various materials and, therefore, permit one to laminate a polyamic acid layer onto another material, e.g., other polymeric or non-polymeric layers, without the use of additional solvents.

The present invention also provides a method for forming such a free-standing polyamic acid film which comprises applying a polyamic acid in a solution to a casting substrate, generally partially removing the solvent from the polyamic acid solution by heating, removing the free-standing polyamic acid film which is free from phthalic acids and uniquely applying the film to the substrate of interest via non-conventional methods, for example, laminating the film to a package substrate at elevated temperature and pressure, and curing the laminated, free-standing polyamic acid film to the corresponding polyimide.

The process of the present invention, unlike the prior art, does not require repeated solvent removal steps to build thick layers from the polyamic acid that is present on the package substrate of interest. The removal of solvent is believed to be the primary cause of the initial interfacial stress between the polymer and substrate.

It is to be specifically noted that in the process of the present invention, one applies the dielectric to the package substrate in a unique manner, e.g., lamination.

The free-standing polyamic acid film finds particular use as a dielectric between electrically conducting layers in second level packaging (SLP) applications.

A major benefit of the use of the free-standing polyamic acid films of the present invention is that they permit much more rapid SLP processing than conventional prior art techniques.

A further major benefit of the present invention is that the free-standing polyamic acid films can be quality assured prior to lamination; following the prior art, since the polyamic acid layer(s) are first present on the final device when quality assurance is done, if defective it was necessary to discard or rework the entire device.

An additional major benefit of the present invention is that one can process not only polyimides in general but rigid rod polyimides into a second level package substrate with increased thickness and excellent control over material uniformity as compared to the prior art.

In a further aspect of the present invention, thermoplastic polyimide adhesive precursors are used to yield a thermoplastic polyimide adhesive layer, desirably to bond independently fabricated circuit layers into multi-layer structures, a process for using such thermoplastic polyimide adhesive layers also being disclosed.

The present invention provides a unique approach which permits polyamic acids to be applied via non-conventional methods to substrates. For example, the present invention provides a unique method which allows polyamic acids to be obtained as a "free-standing film", i.e., a film, which does not require support such as a substrate, ring, clamp, or the like, and thus extends the processing techniques which can be used to adhere or laminate such a free-standing polyamic acid film to other substrates using other techniques, for example, lamination, rolling and calendaring processing.

In addition, by utilizing free-standing polyamic acid films several distinct advantages are encountered. For example, thicker films can be obtained (deposited on the substrate) with excellent control and uniformity. In addition, this method reduces the large internal stresses that result during the conventional solvent removal or drying step of the prior art.

Further, multi-layer polyamic acid film composites are possible, that is, a dielectric consisting of several different types of polyamic acids on a substrate. Once cured, the dielectric is a multi-layered polyimide composite. Other multi-layered composites could include, for example, multi-layers of polyimide with other high temperature/high performance polymers such as polyquinolines, polyphenyl quinoxalines, polybenzimidazoles, polyimide/amides, etc., metals such as copper, aluminum, etc., ceramics such as alumina, silicon, oxidized silicon, etc.

Multi-layer composites of different polyimides provide the unique opportunity to tailor fit the dielectric's physical properties to that of the substrate. For instance, tailor fitting the dielectric's CTE (coefficient of thermal expansion) to match that of the substrate can alleviate interfacial stresses resulting from CTE mismatch between the CTE of the dielectric and that of the substrate. In addition, with lower dielectric polyimides/polyamic acids becoming available, dielectric variations of the overall composite can potentially be modified as specified by the electronic/electrical design.

The present invention further offers the advantage of facilitating precise thickness control and uniformity of thick films.

Since the flatness and character of the casting support can be controlled (typically it is a glass plate cleaned by, e.g., acid cleaning, for example, using hydrofluoric acid), one can control and know the nature of the casting support and, as a consequence, know and control the nature of the resulting free standing

polyamic acid film.

Finally, and this is quite important, the deposited films' thermal history is homogeneous, thus providing an improved environment for the completion of imidization. Thus, the entire dielectric as applied to the substrate is exposed to a common (same) cure/thermal cycle and has seen the same thermal history. In distinction, the individual components making up prior art thick films have differing thermal histories, i.e., the first layer deposited will have gone through all the cure/thermal cycles of each subsequent layer whereas, of course, the last layer deposited will only have gone through one cure/thermal cycle.

To illustrate one simplified application of the free-standing polyamic acid film of the present invention such would be as follows. A metal substrate, e.g., copper, silver, or aluminum, has a free-standing polyamic acid film applied to both sides thereof and the same are laminated to both sides thereof. Curing is then conducted, whereafter signal lines are applied to the resulting polyimide layers in the package. The resulting structure is a simple 2S 1P structure.

The free-standing polyamic acid films of the present invention also find particular use in SLP manufacture. Such SLP may utilize a plurality of metal core cards. A metal core card may typically be a copper sheet with vias therein. The polyamic acid coats both sides of the metal core card and fills any vias, if present, and the vias, if desired, can then be reopened, the polyamic acid generally cured and then the via, if they have been reopened, are metallized with a conductor forming, for example, a conducting path between both sides of the polyimide coated metal core card. If desired, of course, the polyamic acid could be cured to the corresponding polyimide and then the vias reopened and metallized. The term via includes both through and blind vias. In the case of the blind vias, the blind vias can form an electrical connection between the conductive substrate and the surface metallurgy. The above substrate coating procedure and via filling procedure are possible because the free standing polyamic acid film of the present invention behaves like a thermoplastic, i.e., is processable.

Using a free-standing polyamic acid film in accordance with the present invention, the desired vias may be opened by punching (mechanical) or drilling (mechanical or with light, i.e., laser ablation). Etching may also prove to be attractive for some applications. Such procedures are substantially simpler than is used in the prior art where, after spinning a liquid polyamic acid solution onto an SLP, the vias which have to correspond to the vias in the SLP are typically etched through the polyamic acid layer to correspond to the vias in the SLP.

The free-standing polyamic acid films of the present invention can be successfully adhered to a number of substrates as are typically used in the electronics industry. Typical non-limiting examples include: metals such as copper, aluminum, metals having a specific sputtered surface, e.g., chrome sputtered copper, copper/invar/copper, etc., another free-standing polyamic acid film; a polyimide; ceramics such as between alumina, silicon, oxidized silicon, etc.

The present invention is applicable to polyamic acids in general which can be put in solution and finds special application with polyamic acids which will yield a rigid rod polyimide. The resulting polyimides from such rigid rod polyimide precursors provide advantages over general polyimides, primarily a low coefficient of thermal expansion (CTE).

For example, when a polymer is placed on a metal and the combination is heated or cooled, if the CTE of the metal and the polymer are drastically different stress will result at the interface between the metal and the polymer and if this stress is too high, delamination can result. Rigid rod polyimides can have a CTE less than or similar to those of metals and thus reduce the potential problem of interface stress and lowered product yield due to delamination at the metal/polymer interface.

If a dielectric/substrate CTE mismatch is present, one can also use composite polyimides and tailor fit the CTE of the resulting composite dielectric to the metal substrate used. For instance, Pyrallin 2611 has a CTE of about 3 ppm/°C whereas the CTE of Pyrallin 2525 is much higher. By selecting the desired blending ratio of these two polyimides, one can tailor fit the CTE of the polyimide composite to that of the metal it will be laminated to.

Polyamic acids are normally formed by the reaction of an aromatic dianhydride and an aromatic diamine in a polar organic solvent. The polyamic acid precursors typically have the following formula:

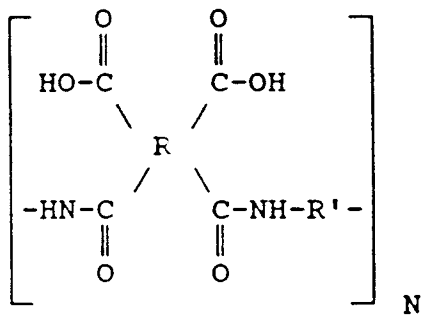

where,

R is an aromatic tetravalent radical,

R' is a divalent aromatic radical, and

N is sufficient to give a polyamic acid with $\eta_{red}$ of 0.5 or greater in DMAc containing 0.1 mole/liter lithium bromide.

The polyamic acids we contemplate as useful will generally have a weight average molecular weight on the order of about 20,000 to about 200,000, but the present invention is not limited thereto. Usually the ratio of the weight average molecular weight/number average molecular weight is about 2 since the polyamic acids are linear condensation polymers.

The polyamic acid cures upon heating to form an insoluble polyimide having the following repeating structure:

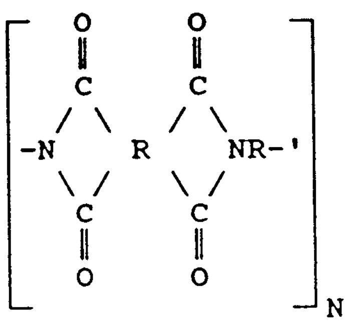

where R and $R^1$ are as defined above.

In addition to polyamic acid formed from pyromellitic dianhydride and oxydianiline, the following reactants should also be useful to yield polyamic acids which form free-standing polyamic acid films in accordance with the present invention.

Among the aromatic dianhydrides contemplated as useful within the scope of this invention are 2,3,6,7-naphthalene tetracarboxylic dianhydride; 1,2,5,6-naphthalene tetracarboxylic dianhydride; bis(3,4-dicarboxyphenyl) sulfone dianhydride; perylene 3,4,9,10-tetracarcoxylic acid dianhydride; bis(3,4-dicarboxyphenyl) ether dianhydride; etc.

Among the aromatic diamines contemplated as useful in this invention are 4,4'-diaminodiphenyl ether; 5-amino-2-(p-aminophenyl)benzothiazole; 4-amino-2-(p-aminophenyl)benzothiazole; 5-amino-2-(m-aminophenyl)benzothiazole; 5-amino-2-(p-aminophenyl)benzoxazole; 4-amino-2-(m-aminophenyl)-benzothiazole; p- and m-phenylene diamine; 4,4'-diaminobiphenyl)benzoxazole; 5-amino-2-(m-aminophenyl)-benzoxazole;4-amino-2-(m-aminophenyl benzoxazole; 2,5-diamino benzoxazole; 2,5-diamino benzothiazole; etc.

The polyamic acid may be formed in accordance with the prior art, for example, in accordance with U.S. Patents 3,179,614 and 3,179,634 or U.S. Patent No. 4,522,880. Polyamic acid solutions useful to form the free-standing film of the present invention are also commercially available.

Although N-methyl-2-pyrrolidone (NMP) is the preferred solvent, other solvents which should be useful in accordance with the present invention include dimethylacetamide (DMAc), other polar organic solvents such as N,N-dimethylmethoxy acetamide, dimethylformamide (DMF), diethyl formamide, and dimethylsulfoxide (DMSO). Still others potentially should be useful, e.g., N-methyl caprolactam, dimethyl sulfone,

pyridine, hexamethyl phosphoramide, N-acetyl-2-pyrrolidone, tetramethyl urea and tetramethylene-sulfone.

Although we typically utilize commercially available polyamic acid solutions, we contemplate that polyamic acid solutions having a solid content of from about 5 to about 50 percent by weight based on the total weight of polyamic acid plus solvent(s), should be useful in accordance with the present invention. Typically, the polyamic acid solution is simply the polyamic acid plus one or more solvents. In this instance, the polyamic acid solution would comprise from about 95 to about 50 percent by weight of one or more solvents.

Subsequent to partial solvent removal but prior to lamination, we contemplate that a free standing polyamic acid film will most often contain up to about 30 wt% solvent, based on total film weight.

This aspect of the present invention should be compared to the attempt to use fully cured polyimide films in the prior art, especially rigid rod type systems such as BPDA-PPD. Such fully cured films are, on a production line, easy to physically handle, but will not adhere sufficiently, as they are, to a package substrate (typically Cu or Cu/invar/Cu) since they will not undergo viscoelastic flow under the application of heat and pressure. The free standing polyamic acid film of the present invention exhibits viscoelastic flow during lamination to facilitate processing, providing excellent adhesion to the substrate and can be cured to yield the desired polyimide dielectric.

The thickness of the free-standing polyamic acid film can be freely varied depending upon the contemplated final use, but with most commercially available materials we would expect a final free-standing polyamic acid film thickness of from about 0.006 mm (0.25 mil) to about 0.635 mm (25 mils) to find relatively wide application. As one skilled in the art will appreciate, factors which influence the deposited film's thickness can include spin speed and solution viscosity which itself depends on percent solids and molecular weight. One skilled in the art can easily balance these factors to obtain the desired thickness.

When we use a multi-layer composite of layers of different free-standing polyamic acid films, we again expect the multi-layer composite will have a total thickness of about 0.006 mm (0.25 mil) to about 0.635 mm (25 mils). Individual free-standing polyamic acid layers in the composite can have any desired thickness with the individual layer of greatest thickness generally exhibiting the greatest influence on the characteristics of the composite.

Typically the polyamic acid solution is applied in a conventional manner, for example, spin casting, onto appropriate substrates such as a glass plate. Of course, any other conventional means can be used to apply the polyamic acid solution, e.g., draw down bar/doctor blade, spraying, dipping, meniscus coating, etc., and the present invention is not limited in this regard. A flat, clean glass plate is the preferred substrate.

Solvent present is normally then partially removed by heating to a temperature of from about 30 to about 80 °C for about 10 minutes to about 30 minutes in air at normal pressure. If desired, vacuum can be used to aid solvent removal as can other ambients such as N2, Ar, etc., but we currently see no benefits to such modifications. Normally, following drying and prior to lamination, the free standing polyamic acid film will be about 25 to about 30 percent by weight solvent for most applications, based on total film weight.

Of course, we contemplate that greater amounts of solvent could be removed from the polyamic acid while on the casting substrate so long as the polyamic acid characteristics thereof are not lost, namely the free standing nature thereof and the ability to undergo lamination to a package substrate and cure to the complete polyimide form. Thus, some, but not excessive imidization, is acceptable.

Also, by simple control of the temperature and time of drying, the removable free standing polyamic acid film can contain a known amount of solvent to achieve a desired plasticizing effect dependent on the amount of solvent. Thus, the free standing polyamic acid film can be adhered to the desired package substrate without using any new polymers, plasticizers or chemical modification methods, e.g., making the ester of the polyamic acid. The resulting free standing polyamic acid film can thus be inherently "tacky". This is a consequence of the fact that the free standing polyamic acid film is generally not fully chemically cured on the casting substrate prior to removal.

The free-standing polyamic film/substrate combination is then permitted to cool in any desired fashion.

The free-standing polyamic acid film normally at this stage will have a solvent concentration no greater than about 30 percent by weight based on the total weight of the free-standing polyamic acid film and will be free of phthalic acids as in, e.g., prior art where phthalic acids are used to esterify the polyamic acid, a situation not contemplated for the present invention.

At that stage, the film is ready for application to the desired substrate.

With the ability to control the physical characteristics of the free standing polyamic acid films from run to run, high level quality assurance is virtually guaranteed. However, and this is another unique aspect of the present invention, if some problem is encountered one can simply reject a defective free standing polyamic acid film prior to package substrate lay up. This is quite contrary to the prior art where quality

assurance could usually only be done after package substrate lay up. If a defective polyamic acid component was encountered, generally the complete package had to be discarded or reworked.

Following application to the desired substrate, lamination is typically effected under applied pressure and at an elevated temperature, for example, at a pressure of from about 34.474 bar (500 psi) to about 68.948 bar (1,000 psi) and at a temperature of from about 60 °C to about 100 °C, whereby the free-standing polyamic acid film is brought into intimate contact with the substrate and vias are filled, if they are present. The present invention is not limited to such pressures and temperatures, of course.

We most prefer to process at increasing temperatures but using one pressure since it is rather easy to generate an increasing temperature profile, though one could increase the pressure during processing. Since we generally use temperatures during lamination similar to those used during the drying step to a first order of approximation, it is contemplated that negligible or no solvent will be lost during lamination.

Although we contemplate lamination at a single preset temperature and pressure to be useful, in the later presented Examples we used a multi-temperature lamination due to our greater familiarity with multi-step lamination processes.

The process window regarding time of lamination is very broad, so long as intimate contact is made with the substrate and, if vias are to be filled, they are filled. For example, typically a total lamination will take from about 30 to about 60 minutes from beginning of heating of the press to final cool down. The atmosphere for lamination is air, though those recited for solvent removal are believed useful.

Following lamination, typically thermal curing of the free-standing polyamic acid film to the final substrate, i.e., a polyimide, is conducted. Normally thermal curing is conducted under an inert gas atmosphere such as, for instance, nitrogen, argon, helium and the like, typically nitrogen. Thermal curing results in the removal of all solvent present, if any, and in conversion of the polyamic acid to the corresponding polyimide. The pressure of the atmosphere is typically just slightly above atmospheric to purge oxygen.

At present, we use thermal curing of the free-standing polyamic acid film to the corresponding polyimide, but we contemplate chemical curing of the free-standing polyamic acid film to the corresponding polyimide should also be useful. Useful chemically curable polyamic acids should include the materials such as PMDA/ODA with curing agents such as anhydrides in amounts as are conventionally used in the art. Such chemically cured polyimide acids are available from DuPont.

Since we have concentrated on thermal curing, the following discussion will be in terms of thermal curing.

While in theory one could contemplate a single temperature curing, as a practical matter we find it much more convenient to use a stepped curing procedure where the temperature of the laminate is gradually increased and the laminate is held at the desired temperature for the desired period of time to effect thermal curing.

We currently contemplate the following thermal curing schedule to be of general application.

For example, assuming a start at room temperature, typically the temperature of the laminate will be increased at a heating rate of about 3 °C/min. to about 5 °C/min. to the desired first curing temperature. Usually the first curing temperature can be from about 80 °C to about 100 °C and the laminate will be held at that temperature for from about 30 minutes to about 60 minutes.

Typically, the temperature is then elevated to a second curing stage temperature normally at a rate of from about 3 °C to about 5 °C until the second curing temperature of from about 150 °C to about 325 °C is reached, whereafter curing is conducted for about 30 minutes to about 60 minutes at that temperature.

More than two curing temperatures can be used, for example, one could then use a third or even more curing stages.

If used, a typical third or subsequent curing stage would involve raising the temperature of the laminate from the second curing stage temperature to a temperature above about 325 °C at a temperature elevation rate of from about 3 °C/min. to about 5 °C/min., whereafter curing at this final temperature would be conducted for about 30 minutes to about 60 minutes. If a third or higher curing stage is used, it is desirable that the polyimide be subjected to the maximum temperature it will see in subsequent processing steps, that is, processing steps after the last curing stage.

However, we currently contemplate that for each of the above temperature elevation steps a temperature elevation rate of about 0.1 to about 40 °C/min. should include most practical applications.

It is important that the temperatures involved not result in any by-products which would result in phthalic acids or any other harmful by-products which are absent from the film of the present invention.

This completes basic processing in accordance with the present invention, whereafter the cured laminate can be removed, permitted to cool and the same is ready for use in finishing processing, as appropriate.

The present invention thus provides a unique product and process which allows greater application of polyamic acids to substrates, providing not only excellent adhesion and coverage to the substrate, but in the instance of multi-layer polyamic acid lay-ups, outstanding adhesion of itself.

The capability to use other than conventional application methods such as spray, dip, spin coating, etc., has been expanded to include lamination, roll and calendaring which permit enhanced thickness deposition of the polyamic acids applied and offer excellent and reproducible material deposition on the substrate, improved imidization of thicker films due, in part, to the fact that in the case of single polyamic acid application the layer has been exposed to an identical thermal history. This is also true for multi-layer polyamic acid layers. Each individual layer (component) has the same thermal history.

If one could form all the desired polyamic acid films prior to lamination without any different thermal history being applied to each film, obviously ultimate device predictability will be greatly improved over the situation where each additional individual film will have been subjected to an additional thermal treatment.

For multi-layer polyamic acid applications, the polyimide composite layers which result can be produced with precisely controlled thicknesses. This provides the opportunity to control the physical properties of the overall dielectric by ratioing, depending on the end use requirements, the quantity of each material deposited comprising the composite polyimide.

An inherent characteristic of a free standing polyamic acid film formed per the present invention is the ability to freely handle and use the same to form an electronic package lay up without substantially altering the characteristics thereof until curing. Thus, the complete final desired lay up can be assembled in a simple fashion in a manner similar to making a sandwich, whereafter lamination and curing to the imide form can be effected to yield the final desired electronic package.

While the polyimides, including the rigid rod polyimides, which have been discussed up to this point, are highly useful in forming simple 2S 1P structures, these polyimides alone are difficult to use as a dielectric for 2nd Level multi-layer packaging applications, (SLP applications) using conventional fabrication processes. One of the difficulties encountered in using such polyimides in SLP applications is the poor adhesion which is encountered between two fully cured polyimide layers. As a consequence, to use a polyimide such as a high Tg rigid rod polyimide as a dielectric in SLP applications, it is necessary to employ either a suitable surface modification scheme or a suitable high temperature adhesive must be used which would exhibit good adhesion not only to itself but also to the earlier discussed polyimides (high Tg rigid rod polyimides) as well as other polymeric and non-polymeric materials.

In another aspect of the present invention, we have discovered that it is possible to use a thermoplastic polyimide as an adhesive layer to bond independently fabricated circuit layers into multi-layer structures. Most importantly, the circuit layers can be formed using polyimides as earlier discussed, most preferably low CTE, high Tg rigid rod polyimides such as BPDA-PDA, as the bulk dielectric.

In the preceding portions of this disclosure, we have discussed, inter alia, a unique processing method for applying polyimide dielectrics onto substrates, such as metals, using a free-standing polyamic acid film. Such process not only provides a polyimide dielectric having good adhesion and coverage of the substrate surface, but provides full and complete insulation of vias, either blind or through, if present. The process, however, under conditions of fully cured and solventless dielectric layers, is limited to the fabrication of a single layer up to a 2S 1P structure.

In accordance with a further aspect of the present invention, by further utilizing a thermoplastic polyimide as an adhesive, we provide the art with a method by which fully cured solvent-less polyimide layers may be used to fabricate multi-layer structures which utilize the excellent properties of the polyimides earlier discussed as a bulk dielectric. As an example, in accordance with the earlier portion of this disclosure, one can use the free standing polyamic acid films and laminate one of such films on both sides of a desired substrate as earlier discussed and then cure the polyamic acid films to the corresponding polyimides. Metallization can then be formed in a conventional manner on one or both of the cured polyimide films. We also contemplate it should be feasible to metallize the polyamic acid films prior to curing the same, though this is not preferred.

As discussed in more detail hereafter, a polyamic acid precursor of a thermoplastic polyimide adhesive can be applied to the free standing polyamic acid film, or the cured polyimide resulting from the free standing polyamic acid film, on one or both sides of the initial bulk dielectric/substrate/bulk dielectric assembly, where the free standing polyamic acid film or the cured polyimide resulting therefrom may or may not be metallized. Thereafter, the thermoplastic polyimide adhesive precursor layer is cured or, if the free standing polyamic acid film which is to yield the bulk polyimide dielectric has not been cured, both the thermoplastic polyimide adhesive precursor layer and the free standing polyamic acid film are cured together. The thermoplastic polyimide adhesive precursor is also free of phthalic acids.

We currently prefer to apply metallization to the cured thermoplastic polyimide adhesive rather than to

the uncured but dried form thereof. Theoretically, however, it should be feasible to metallize the uncured but dried precursor prior to conversion to the cured thermoplastic polyimide adhesive. We also currently prefer to apply the metallization only to the cured thermoplastic polyimide adhesive layer(s) present rather than to the bulk polyimide dielectric.

Thus, one basic building block of this aspect of the present invention comprises, in the ready to laminate form, cured polyimide thermoplastic adhesive layer/metallization/cured bulk polyimide dielectric/ substrate/cured bulk polyimide/dielectric/ metallization/cured thermoplastic polyamic adhesive.

Another basic building block in this aspect of the present invention comprises in the the ready to laminate form, metallization/cured polyimide thermoplastic adhesive layer/bulk polyimide dielectric/substrate/cured bulk polyimide dielectric/cured thermoplastic adhesive layer/ metallization. This is the currently preferred form.

In theory, only one side of the substrate, typically a conductive substrate, could carry the layers in the indicated sequences, and only one of the bulk polyimide dielectric layers or thermoplastic polyimide adhesive layers need be metallized, but we contemplate that in most instances the substrate will carry the layers in the indicated sequence on both sides and both of the bulk polyimide dielectric layers or the thermoplastic adhesive layers will be metallized.

The above described structure can be laminated at one or both cured thermoplastic polyimide adhesive layers to identical or similar structures containing outermost cured thermoplastic polyimide adhesive layers, and this procedure can be repeated the needed number of times until the ultimate desired structure is obtained.

In a manner similar to that used for the free standing polyamic acid films used to form the bulk polyimide dielectric, the thermoplastic polyimide adhesive of the present invention can be applied as what can be considered a free-standing thermoplastic polyamic acid adhesive film. Although generally at a lesser thickness, such a free-standing thermoplastic polyamic acid adhesive film can be formed as earlier described for the free-standing polyamic acid film which will yield a bulk polyimide dielectric layer in accordance with the present invention. Alternatively, the thermoplastic polyamic acid layer can be applied as a "precursor" polyamic acid in solution to the bulk polyimide dielectric layer (the cured polyimide) or the free-standing polyamic acid film which will yield the cured polyimide. In this latter case, one does not go through the free-standing film stage for the thermoplastic polyamic acid adhesive film. Concentration of solutions, solvents, molecular weight, partial solvent removal conditions, solvent concentration in the adhesive layer, lamination conditions and curing conditions as described for forming the free standing polyamic acid film are also used to form the thermoplastic polyimide adhesive layer or the free-standing form thereof. The thermoplastic polyimide adhesive layer will, however, in final cured form, normally be thinner than the bulk polyimide dielectric layer, and will typically be less than about 0.025 mm (1 mil) thick, though thicker applications are contemplated as useful. It is only necessary that the cured thermoplastic adhesive layer be thick enough to exhibit its adhesive function.

As earlier indicated, the thermoplastic polyimide adhesive precursor can be applied to either a free standing polyamic acid film formed in accordance with the present invention or the cured polyimide which results therefrom.

Upon curing of the thermoplastic polyimide adhesive precursor an extremely strong joining interface created between the two different polyimide materials.

In the case that the thermoplastic polyimide adhesive precursor is applied to a free standing polyamic acid film, both can then be simultaneously cured using the conditions earlier given for curing the free standing polyamic acid film. If a third cure is used, the curing temperature can be, for example, on the order of about 300 to about 350 °C, as exemplified in later Example 4 where a third cure at 325 °C is used. In the situation where the free-standing polyamic acid film has been imidized to the corresponding polyimide, again the thermoplastic polyimide adhesive can be cured using the conditions earlier given for curing the free standing polyamic acid film except that if a third cure is used it can be at a temperature on the order of about 300 to 350 °C.

During curing, the solvent content of the thermoplastic polyimide adhesive is decreased to 0 as is the case with the free standing polyamic acid film during curing.

Turning now to the nature of the thermoplastic polyimide adhesive, thermoplastic polyimide adhesives as are conventionally used in the art can be used in the present invention. One commercially available material is Du Pont PI-2566 which is used in Example 4.

Other thermoplastic polyimide adhesives contemplated as useful in the present application include the fluorinated materials disclosed in U.S. Patent 4,111,906 Jones, et al, hereby incorporated by reference.

In addition, the thermoplastic polyimide adhesive precursors marketed by Rogers Corporation under the tradename Durimid may be used in the present invention.

Additional thermoplastic polyimide adhesives contemplated as useful in the present invention include the following, all of which show good mechanical properties.

BPDA-BDAF

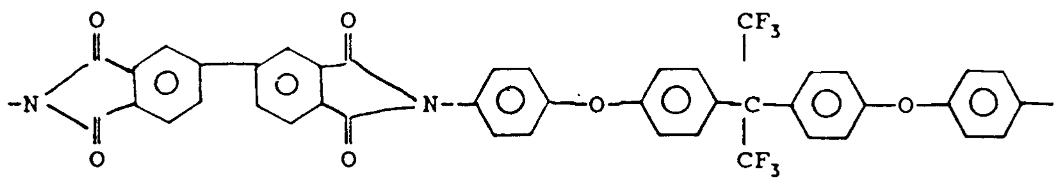

Tg = 250°C;

(disclosed in the Jones et al Patent);

ODPA-ODA

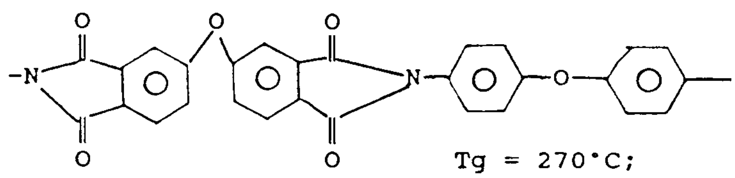

Tg = 270°C;

BTDA-BDAF

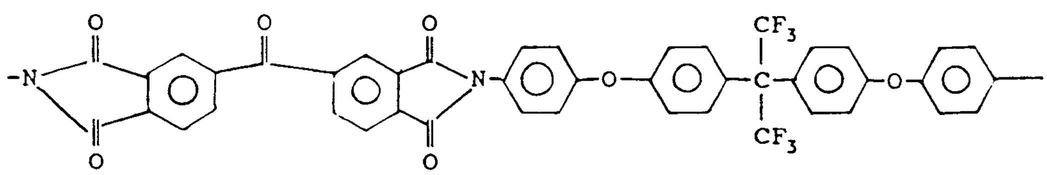

Tg = 250°C;

6FDA-ODA

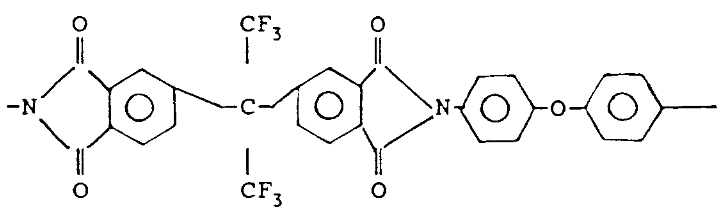

We also contemplate that the following monomers, in combination, will give thermoplastic polyimide adhesives useful in the present invention and which will have a 400°C thermal stability.

Anhydrides

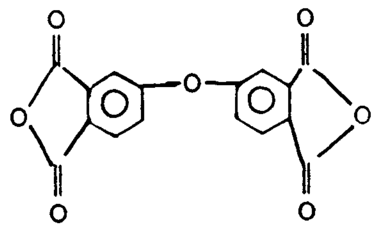

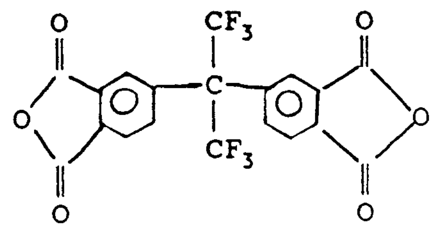

Others

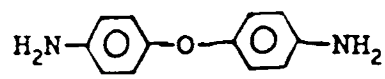

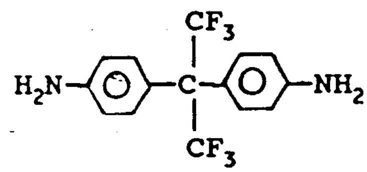

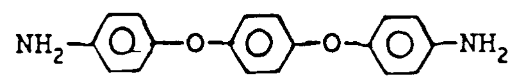

Having thus generally described the invention, the following non-limiting examples are presented to exemplify the currently preferred best modes of practicing the invention.

In the Examples, polyamic acid solutions available from DuPont were used.

In Example 1, the polyamic acid used was BPDA/PPD (biphenyldianhydride/1,4-phenylenedi-amine). This polyamic acid is available from DuPont as Pyralin 2611. Pyralin 2611 has a 13.5% solids content and a viscosity of 10.0 to 13.5 Pa • s (100 to 135 poise).

In Example 2, Pyralin 2525 was used. It has a viscosity of 5 to 7 Pa • s (50 to 70 poise) and is of the BTDA/ODA/MPD type (benzophenonetetracarboxylic dianhydride/oxydi-aniline/metaphenylene diamine).

In Example 3, the polyamic acid solutions of Examples 1 and 2 were used in combination.

In Example 4, a thermoplastic polyimide adhesive was used. It is described in Example 4.

Example 1

A polyamic acid solution of BPDA/PPD in NMP having a solids content of 14.5% (by weight based on solution weight) was applied to a 152.4 mm x 152.4 mm (6 x 6 inch) glass plate and spun on a Headways Research Spin Coater at 1,000 $min^{-1}$ (rpm) for 60 seconds. The thickness of the polyamic acid solution at this point was about 0.038 - 0.051 mm (1.5-2.0 mils).

The glass plate/polyamic acid composite was then placed in a Fisher High Temperature Convection Oven and maintained at 80° C for 20 minutes. The ambient atmosphere was air.

The glass plate/polyamic acid was then removed and allowed to naturally cool, permitting easy removal of the thus formed free-standing polyamic acid film. The solvent concentration of the free-standing polyamic acid film was about 25 to 30% based on total film weight. The thickness of the free-standing polyamic acid film was about 0.038 - 0.051 mm (1.5 to 2.0 mils).

This procedure was repeated a number of times to obtain a number of film samples.

Two of the resulting free-standing polyamic acid films were then applied to both sides of a 0.1 μm (1,000 Å) chrome sputtered 0.025 mm (1 mil) copper/invar/copper substrate and laminated under the following conditions using a Tetrahedron 50 ton, one opening, hydraulic press; the press' platens were 0.356 m x 0.356 m (14 inches x 14 inches).

80° C for 20 minutes at 68.95 bar (1,000 psi) (the rate of initial heat-up is not important but we would expect a temperature elevation rate of about 0.1 to about 40° C/min to provide a reasonable working range);

Temperature raised to 90° C at a rate of 10° C per minute;

90° C for 20 minutes at 68.95 bar (1,000 psi);

Temperature raised to 100° C at a rate of 10° C per minute;

100° C for 20 minutes at 68.95 bar (1,000 psi).

For the above lamination, the ambient was air.

The laminated part was then removed, permitted to cool and thermally cured in a Fisher High

Temperature Oven under a nitrogen gas purge throughout the curing cycle under the following conditions using a heating rate of 3° C/min.:
Room temperature to 100° C and maintained at 100° C for 30 minutes;

100° C to 200° C and maintained at 200° C for 30 minutes.

A third cure, typically at greater than about 325° C, was used for 60 minutes.

The completed laminate was then removed from the oven.

Similar results were obtained for various dwell times.

Example 2

The exact procedure of Example 1 was followed but the BPDA/PPD was replaced with Pyralin 2525, a polyamic acid available from DuPont having a solids concentration of 25% NMP, same basis as earlier given.

Results analogous to those obtained in Example 1 were obtained.

Example 3

The same procedure as described in Example 1 was utilized, but both the BPDA/PPD and Pyralin 2525 films were used in the lamination lay-up to provide a final structure consisting of a copper/invar/copper core having a polyimide composite dielectric, that is, a structure of the following sequence:
Pyralin 2525/BPDAPPD/chrome sputter copper/invar/copper chrome sputter/BPDAPPD/ Pyralin 2525.

The thickness of the composite free-standing bulk polyimide films on each side of the copper/invar/copper core was 0.025 mm (1 mil) (as cured), where the Pyralin 2525 and the BPDA/PPD layers each had a thickness of about 0.013 mm ($\frac{1}{2}$ mil) (as cured).

Example 4

A low CTE rigid rod polyamic acid, the BPDA/PPD as used in Example 1, which is a 14.5% solids solution of BPDA-PPD in NMP from Dupont, was formed into a free-standing polyamic acid film having a thickness of about 0.038 to 0.508 mm (1.5 to 2.0 mils) following the procedure of Example 1. One such free-standing polyamic acid film was applied to each side of a one mil copper/invar/copper foil which had been sputter coated in a conventional manner with about 2,000 A of Cr. Lamination was then conducted using the conditions in Example 1.

Prior to imidization (cure), a layer of a polyamic acid precursor to a thermoplastic polyimide adhesive, Pyralin 2566 (solids content of 17.5% by weight based on solution weight of the thermoplastic polyimide adhesive precursor 6FDA-ODA) was spun onto both of the free-standing polyamic acid films. The thickness of the adhesive precursor was about 2 to 4 µm. Pyralin 2566 is available from Du Pont and is a 6FDA-ODA polyamic acid which is a fluorinated electronic grade polyimide. This polyimide is considered to be partially fluorinated having 6FDA, a fluorinated dianhydride, polymerized with ODA. As an equivalent or alternative, a BPDA-BDAF solution in NMP having a solids content of 10% (by weight based on solution weight) can be used.

The structure was then cured in a nitrogen purged oven under the following conditions. Again, the temperature elevation rate from room temperature to the first cure temperature is not important and the discussion in Example 1 on this point applies. The temperature was raised at 3° C/min from 100 to 200 and from 200 to about 325° C in this example.

In more detail, the described solution of the polyimide acid precursor to the thermoplastic polyimide adhesive was spun onto one layer of the free-standing polyamic acid film and then baked at 80° C for twenty minutes in a Fisher High Temperature Convection Oven in air. An identical layer of the polyamic acid precursor to the thermoplastic polyimide adhesive was then spun onto the other free-standing polyamic acid film and then baked at the same conditions. Of course, a free-standing film of the precursor to the thermoplastic polyimide adhesive could have been used as an alternative.

Room temperature to 100° C, maintained for 60 minutes;

100° C to 200° C, maintained for 60 minutes; and

200° C to about 325° C, maintained for 60 minutes.

With respect to the curing of the thermoplastic polyimide adhesive precursor layer, the curing at 100° C for sixty minutes is primarily a solvent removal step, though we believe that some additional solvent removal occurs during the second cure at 200° C for sixty minutes. It would be accepted by one skilled in the art that virtually all imidization will be completed by the end of the cure at 200° C for sixty minutes.

After curing, two identical parts were stacked and laminated together under the following conditions using a tetrahedron 0.356 m (fourteen inch) press:

Room temperature to above 325 °C, maintained at 64.948 bar (1,000 psi) for 30 minutes. The heating rate was 3 °C per minute. We selected this final lamination temperature to exceed the maximum temperature in any earlier processing step which the thermoplastic polyimide adhesive precursor (or cured adhesive) has encountered.

Cool down to room temperature at 68.948 bar (1,000 psi).

The adhesion between the two cured thermoplastic polyimide adhesive layers was then determined using an Instron tester, Model 1122, using a conventional 180° peel test at a peel rate of 50.8 mm/minute (2"/minute).

The results obtained were as follows:

| Part | Peel Strength (17.858 $\frac{kg}{m}$) (lb/in) |
|---|---|
| Pyralin 2611/Pyralin 2566 | > 2.5 |
| Pyralin 2611/BPDA-BDAF | > 3.5 |

The delamination failure occurred at the bulk polyimide dielectric/metal interface and not at the thermoplastic polyimide adhesive/bulk polyimide dielectric interface, indicating that the adhesion between the thermoplastic polyimide adhesive/bulk polyimide dielectric exceeded that of the bulk polyimide dielectric/metal adhesion.

The present invention thus also provides a method that permits the use of bulk polyimide dielectrics, preferably low CTE rigid rod polyimide dielectrics, to act as bulk dielectric in 2nd level, direct chip attach multi-layer electronic packaging applications.

The invention in this embodiment uses a thin layer of thermoplastic polyimide adhesive as the joining material between successive components of an electronic package. Thus, in accordance with this aspect of the present invention, by coating a thermoplastic polyimide adhesive precursor on a free standing polyamic acid film or such a film which has been cured to the corresponding polyimide, excellent adhesion can be achieved between the two layers.

## Claims

**1.** A structure comprising a free-standing polyamic acid film substantially free of phthalic acids.

**2.** A structure comprising at least one free-standing polyamic acid layer substantially free of phthalic acids on an electrically conducting substrate.

**3.** The structure of claim 1 or of claim 2, where said free-standing polyamic acid film contains less than about 30 weight percent solvent based on the total weight of the free-standing polyamic acid film but yet some solvent.

**4.** The structure of claim 3, where said free-standing polyamic acid film contains from about 25 to 30 weight percent solvent based on the total weight of the free-standing polyamic acid film.

**5.** The structure of claim 1 or of claim 2 which has a thickness of from about 0.006 to about 0.635 mm (about 0.25 to about 25 mils).

**6.** The structure of claim 1 or claim 2, wherein said free-standing polyamic acid film is a rigid rod polyimide precursor.

**7.** The structure of claim 6, wherein said rigid rod polyimide precursor is biphenyldianhydride/1,4-phenylenediamine, benzophenonetetracarboxylic dianhydride/oxydianiline/metaphenylene diamine or a mixture thereof.

**8.** A method of fabricating the structure of claim 1 which comprises:

applying a polyamic acid solution to a casting substrate;

partially removing the solvent from the polyamic acid solution by heating the same;

removing the free-standing polyamic acid film which is substantially free from phthalic acids from the casting substrate.

**9.** A method of fabricating the structure of claim 2 which comprises:

applying a polyamic acid solution in a solvent to a casting substrate;

partially removing the solvent from the polyamic acid solution by heating the same;

removing the free-standing polyamic acid film which is substantially free from phthalic acids;

laminating the free-standing polyamic acid film to an electrically conducting substrate at elevated temperature and pressure; and

thermally curing the laminated, free-standing polyamic acid film to the corresponding polyimide.

**10.** The method of claim 8 or claim 9, wherein the partially removing of the solvent by heating is at a temperature of about 30 to about 80 °C for about 10 minutes to about 30 minutes.

**11.** The method of claim 9, wherein the laminating is at about 34.474 bar (500 psi) to about 68.948 bar (1,000 psi) and at from 60 °C to about 100 °C.

**12.** The method of claim 11, wherein the curing is in at least two stages:

a first stage at about 80 to about 100 °C for about 30 minutes to 60 minutes; and

a second stage at about 150 °C to about 325 °C from about 30 minutes to about 60 minutes.

**13.** The method of claim 12 which comprises at least one further curing stage greater than at about 325 °C for from about 30 minutes to 60 minutes.

**14.** A laminated structure which comprises, in sequence:
a) a substrate;
b) a layer of a cured bulk polyimide dielectric;
c) a layer of patterned metallization; and
d) a layer of a cured thermoplastic polyimide adhesive.

**15.** The laminated structure of claim 14, which further comprises, in sequence, e) at least one additional layer of a cured thermoplastic polyimide adhesive which has been laminated to said layer d) of said cured thermoplastic polyimide adhesive.

**16.** A method for fabricating the structure of claim 14 which comprises

applying a polyamic acid solution in a solvent to a casting substrate;

partially removing the solvent from the polyamic acid solution by heating the same;

removing the free-standing polyamic acid film which is substantially free from phthalic acids;

laminating the free-standing polyamic acid film to an electrically conducting substrate at elevated temperature and pressure;

thermally curing the laminated, free-standing polyamic acid film to the corresponding polyimide to obtain said layer of cured bulk polyimide dielectric;

metallizing the thus cured free-standing polyamic acid film;

applying a thermoplastic polyimide adhesive precursor to said layer of cured bulk polyimide dielectric and metallization and thermally curing the thermoplastic polyimide adhesive precursor to obtain said layer of cured thermoplastic polyimide adhesive.

**17.** A method for fabricating the structure of claim 14 which comprises

applying a polyamic acid solution in a solvent to a casting substrate;

partially removing the solvent from the polyamic acid solution by heating the same;

removing the free-standing polyamic acid film which is substantially free from phthalic acids;

laminating the free-standing polyamic acid film to an electrically conducting substrate at elevated temperature and pressure;

metallizing the free-standing polyamic acid film;

applying a thermoplastic polyimide adhesive precursor to the free-standing polyamic acid film and metallization and thermally curing to simultaneously obtain the cured bulk polyimide dielectric and the layer of cured thermoplastic polyimide adhesive.

European Patent Office

# EUROPEAN SEARCH REPORT

Application Number

EP 91108775.7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US - A - 3 867 500 (TRAYNOR) * Claims * | 1-13 | C 08 J 5/18<br>B 32 B 15/08<br>B 32 B 27/34//<br>(C 08 J 5/18<br>C 08 L 79:08) |
| X | EP - A2 - 0 087 305 (TORAY INDUSTRIES, INC.) * Claims; page 5, line 9 - page 6, line 6; page 8, lines 22-27; example 3; abstract * | 1-10 | |
| X | US - A - 4 675 246 (KUNDINGER et al.) * Claims; column 9, line 45 - column 10, line 64; example 1 * | 1-3, 5-7,9, 11-17 | |
| X | US - A - 4 543 295 (ST. CLAIR et al.) * Claims * | 1,2, 5-7,9, 11,12, 14-17 | |

TECHNICAL FIELDS SEARCHED (Int. Cl.5)

C 08 J
B 32 B

The present search report has been drawn up for all claims

| Place of search | Date of completion of the search | Examiner |
|---|---|---|
| VIENNA | 17-09-1991 | WEIGERSTORFER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document